# EUROPEAN PATENT APPLICATION

(11) **EP 4 383 318 A1**
(43) Date of publication of application: **12.06.2024**
(21) Application number: 23214558.1
(22) Date of filing: 06.12.2023
(51) Int. Cl.: H01L 21/56, H01L 23/498, H01L 21/48, H01L 23/495

(54) **METHOD OF MANUFACTURING SEMICONDUCTOR DEVICES, CORRESPONDING SUBSTRATE AND SEMICONDUCTOR DEVICE**

(30) Priority: 09.12.2022 IT 202200025293
(71) Applicant: STMicroelectronics International N.V., 1228 Plan-les-Ouates, Geneva (CH)
(72) Inventor: MAZZOLA, Mauro, I-24040 Calvenzano (Bergamo) (IT)
(74) Representative: Bosotti, Luciano

(57) **Abstract**

A common electrically conductive substrate (12) is provided for a plurality of semiconductor devices. The common substrate (12) comprises a plurality of substrate portions (12A, 12B) configured (12A) to host at least one respective semiconductor chip (14). The adjacent substrate portions (12A, 12B) have mutually facing sides with elongate sacrificial connecting bars (CB) extending between the mutually facing sides. The electrically conductive substrate (12) is cut (SL) along the length of the elongate sacrificial connecting bars (CB) to provide singulated individual substrate portions (12A, 12B). The elongate sacrificial connecting bars (CB) are provided with an apertured structure comprising apertures (100) distributed along the length of the elongate sacrificial connecting bars (CB) wherein the apertures (100) provide zones of reduced resistance to cutting.

## Description

### Technical field

The description relates to manufacturing semiconductor devices.

Solutions as described herein can be applied to (integrated circuit, IC) semiconductor devices such as power QFN packages, for automotive products, for instance.

### Background

In current manufacturing processes of (integrated circuit) semiconductor devices multiple devices are concurrently processed and finally singulated into individual devices.

During processing, multiple devices are held together in a device strip using metallic connecting structures including (sacrificial) connecting bars running along the periphery of each device.

A singulation step is performed via sawing along vertical and horizontal sawing lines (e.g., after assembly of the devices and subsequent molding) at the connecting bars.

During a complete cut the saw may encounter different materials and different thicknesses such as, for instance, full metal thickness leadframe, resin plus full leadframe thickness, resin plus half leadframe thickness or full resin thickness. The material configuration (e.g., copper or resin) to be removed depends on leadframe design.

It is noted that removal of metal such as copper generates, in comparison with removing resin, certain problems such as increased blade deterioration.

For that reason, reducing in as much as possible the thickness of connecting bars would be desirable. A certain metal (e.g., copper) thickness of the connecting bars (and of the leadframe) is otherwise beneficial in order to keep all the leadframe parts (e.g., leads and die pads) together in a solid structure during processing.

Undesired short-circuits ("shorts") caused by copper smearing, excessive wearing of the blade likely to reduce blade life, clogging of the blade and/or deflection of the blade during cutting are exemplary of other factors that may come into play in connection with the singulation step.

### Object and summary

Solutions as described herein aim at addressing the issues discussed in the foregoing.

Such an object can be achieved via a method having the features set forth in the claims that follow.

One or more embodiments relate to a corresponding substrate for use in manufacturing (integrated circuit) semiconductor devices.

One or more embodiments relate to a corresponding (integrated circuit) semiconductor device.

The claims are an integral part of the technical teaching provided in respect of the embodiments.

In solutions as described herein, apertures, e.g., cross-wise slits (slots) are provided distributed along the length of the elongate sacrificial connecting bars, wherein these apertures provide zones of reduced resistance to cutting.

That is, metallic material (e.g., copper) being removed (absent) from the connecting bars (to be possibly replaced by molding material such as resin) at such apertures, that are optionally provided as through perforations, facilitates the singulation step.

Solutions as described herein cause less deterioration of the blade.

In solutions as described herein alternating portions of metal and resin along the elongate sacrificial connecting bars facilitates clearing the blade from metallic shavings, thus reducing possible metal smearing and/or clogging of the blade.

### Brief description of the several views of the drawings

One or more embodiments will now be described, by way of example only, with reference to the annexed figures, wherein:
Figures 1 is a plan view illustrative of the structure of an integrated circuit (power) semiconductor device,
Figure 2 is illustrative of a step in manufacturing semiconductor devices,
Figure 3 is an enlarged view of the portion of Figure 2 indicated by the arrow III,
Figure 4 is a view the same portion of Figure 2 illustrated in Figure 3 showing an embodiment of the present description,
Figure 5 reproduces on an enlarged scale the portion of Figure 4 indicated by arrow V as resulting from processing according to embodiments of the present description, and
Figures 6A and 6B are illustrative of possible differences between a conventional finished package and a package obtainable via embodiments of the present description.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The headings/references used herein are provided merely for convenience and hence do not define the extent of protection or the scope of the embodiments.

For simplicity and ease of explanation, throughout this description, and unless the context indicates otherwise, like parts or elements are indicated in the various figures with like reference signs, and a corresponding description will not be repeated for each and every figure.

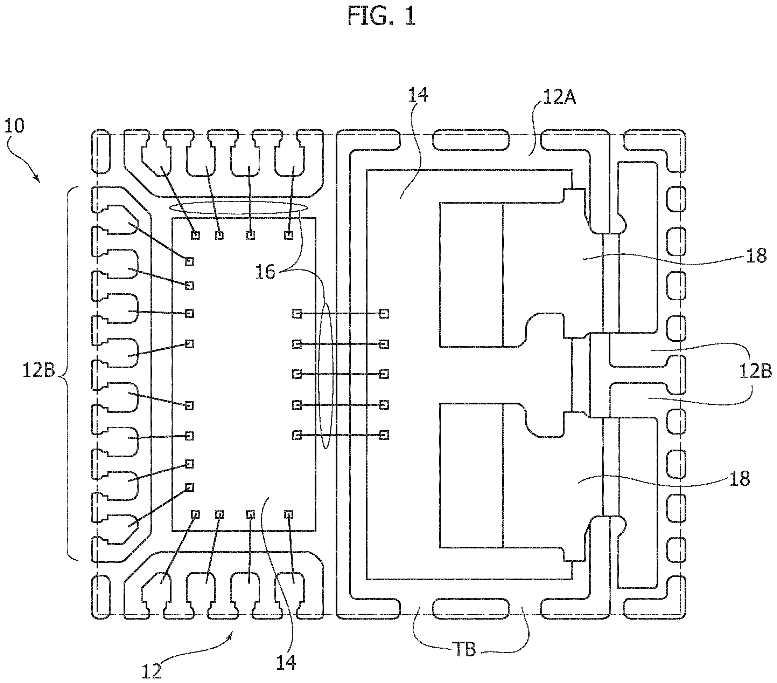

Figure 1 illustrates the structure of an integrated circuit (IC) semiconductor device 10.

The IC semiconductor device illustrated, merely by way of example, in Figure 1 is a power device comprising a low-power section (illustrated on the left-hand side of Figure 1) e.g., a controller die or chip, attached on a first die pad 12A in a leadframe 12 and a high-power section (illustrated on the right-hand side of Figure 1) e.g., one or more power dice or chips attached on one or more die pads 12A in the leadframe 12.

As used herein, the terms chip/s and die/dice are regarded as synonymous.

An array of leads 12B is arranged around the die pads 12A having the low-power and the high-power dice mounted thereon.

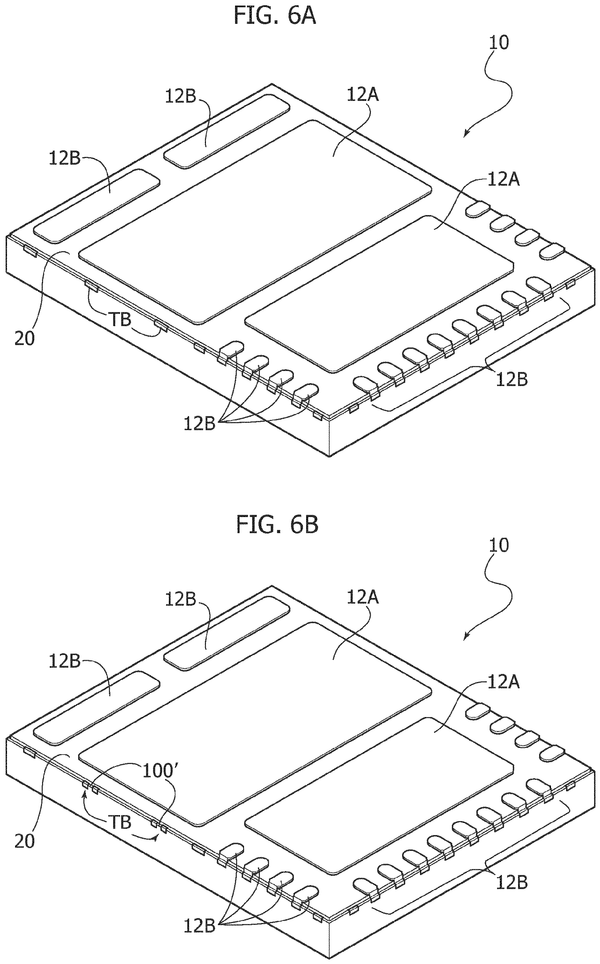

As illustrated herein by way of example, an IC semiconductor device such as the device 10 comprises, in addition to a substrate (leadframe) 12 having one or more semiconductor chips or dice 14 arranged thereon:
electrically conductive formations 16, 18 coupling the semiconductor chip(s) 14 to leads (outer pads) 12B in the substrate, and
an insulating encapsulation (e.g., a resin, visible only in Figures 6A and 6B and designated there with reference 20) molded on the assembly thus formed to complete the plastic body of the device 10.

The designation "leadframe" (or "lead frame") is currently used (see, for instance the USPC Consolidated Glossary of the United States Patent and Trademark Office) to indicate a substrate including a metal frame that provides support for an integrated circuit chip or die as well as electrical leads to interconnect the integrated circuit in the die or chip to other electrical components or contacts.

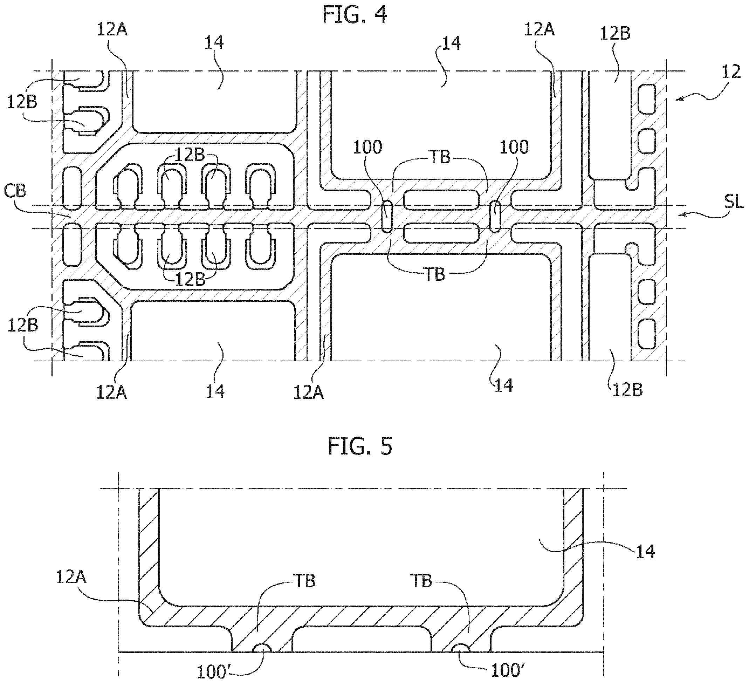

Essentially, a leadframe 12 comprises an array of electrically-conductive formations (or leads, e.g., 12B) that from an outline location extend inwardly in the direction of a semiconductor chip or die (e.g., 14) thus forming an array of electrically-conductive formations from a die pad (e.g., 12A in Figure 4) configured to have at least one (integrated circuit) semiconductor chip or die attached thereon. This may be via conventional means such as a die attach adhesive (a die attach film or DAF, for instance).

In certain cases, a leadframe can be of the pre-molded type, that is a type of leadframe comprising a sculptured metal (e.g., copper) structure formed by etching a metal sheet and comprising empty spaces that are filled by an insulating compound (a resin, for instance) "pre-molded" on the sculptured metal structure.

In current manufacturing processes of (integrated circuit) semiconductor devices plural devices/leadframes are processed concurrently.

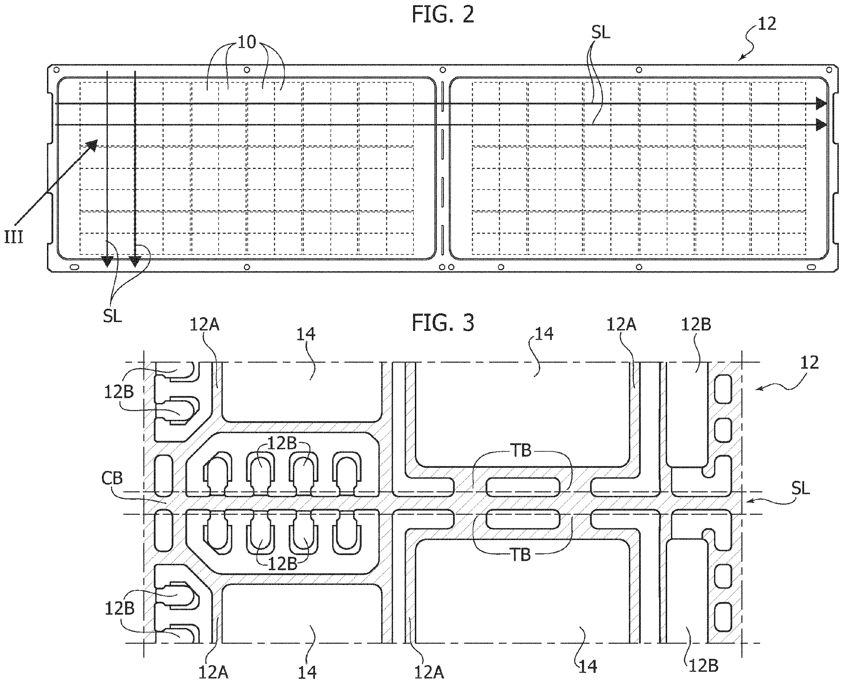

Figure 2 is generally exemplary of a conventional manufacturing process of IC semiconductor devices, wherein a plurality of individual leadframes 12 are provided as a common electrically conductive substrate for use in manufacturing a plurality of semiconductor devices.

For instance, such common electrically conductive substrate can be provided as a plurality of individual leadframes 12 held together in a leadframe strip via connecting formations (visible in Figures 3 and 4, for example, and designated there with the reference CB) extending around the individual leadframes.

For simplicity and ease of understanding, the reference 12 will be applied hereinafter to designate such common electrically conductive substrate.

A process as discussed herein thus essentially involves providing a common electrically conductive substrate 12 (e.g., a leadframe strip) for a plurality of semiconductor devices.

The common substrate 12 visible in Figures 3 and 4 comprises a plurality of substrate portions that, in the example considered herein, include:
die pads 12A configured to host respective semiconductor chips or dice 14 attached thereon, and
electrically conductive leads 12B intended to provide outer contact pads coupled to the chips or dice 14 via electrically conductive formations 16 (wires) and 18 (clips) as represented in Figure 1; these formations 16 and 18 are not visible in Figures 3 and 4.

An insulating encapsulation 20 (e.g., a resin, as illustrated in Figures 6A and 6B) completes the plastic body of a plurality of devices 10 formed on the common substrate 12.

These devices are then "singulated" to individual (integrated circuit) semiconductor devices 10 by cutting (e.g., with a sawing blade) along "horizontal" and "vertical" cutting (sawing) lines SL.

In Figures 3 and 4 just a piece of the common substrate 12 is visible for simplicity with one ("horizontal", by way of example) cutting line SL illustrated at half height in both figures, the cutting line SL thus running between adjacent substrate portions in the common electrically conductive substrate 12.

Figure 3 (and Fguire 4) thus show adjacent substrate portions in the common electrically conductive substrate 12 that:
have mutually facing sides (above and below the cutting line SL in Figures 3 and 4), and
are coupled via connecting formations that comprise elongate (sacrificial) connecting bars CB extending between the mutually facing sides.

Singulating the devices 10 into individual semiconductor devices by cutting along "horizontal" and "vertical" cutting (sawing) lines SL as illustrated in Figure 2 involves cutting the electrically conductive substrate 12 along the length of the elongate sacrificial connecting bars CB that are thus removed (hence the designation "sacrificial").

In the exemplary case considered here, the elongate connecting bars CB are coupled to the facing sides of the adjacent substrate portions in the common electrically conductive substrate 12 via tie bars TB that are distributed along the length of the connecting bars CB and extend transverse thereto. That is, the connecting bars CB are coupled to the rest of the substrates 12 via bridge-like tie bars TB.

As illustrated, the cutting line SL is in fact a (narrow) region between the two dashed lines in Figure 3. During the singulation step, a "distal" portion of the tie bars TB adjacent the connecting bars CB is also removed.

It is noted that the singulation step is usually a final step of a manufacturing process; after arranging the dice 14 on corresponding die pads 12A and providing electrical coupling as desired, a molding compound (an epoxy resin, for instance) is molded onto the assembly to provide a protective plastic package to the device.

In so far as discussed in the foregoing, concurrent processing of plural semiconductor devices to be finally "singulated" is conventional in the art, which makes it unnecessary to provide a more detailed description herein; such processing may involve using tie bars as discussed in documents such as US 7 960 818 B1, US 2020/203262 A1 and US 7 928 542 B2.

Concurrent processing of plural semiconductor devices (which also underlies embodiments as discussed herein) involves providing a common electrically conductive substrate 12 (e.g., a leadframe strip) for a plurality of semiconductor devices.

The common substrate 12 comprises a plurality of substrate portions 12A, 12B, such as individual device leadframes, each configured (e.g., at the die pads 12A) to host at least one respective semiconductor chip 14 mounted (e.g., attached) thereon.

As illustrated in Figure 3 (and Figure 4) adjacent substrate portions 12A, 12B in the common electrically conductive substrate 12 have mutually facing sides and have elongate sacrificial connecting bars CB extending between the mutually facing sides.

Singulation to form individual semiconductor devices 10 involves cutting (e.g., at SL) the electrically conductive substrate 12 along the length of the elongate sacrificial connecting bars CB to provide singulated individual substrate portions 12A, 12B.

As discussed previously, in the singulation step the saw/blade cuts through different materials such as the metal (e.g., copper) of the leadframe and/or the molding compound with various thicknesses.

For instance, the singulation step may have an undesired deteriorating effect on the blade which may reduce blade life significantly.

In fact, cutting through the metal (e.g., removing the metallic connecting bars CB) may cause a more severe deterioration to the saw than cutting through a molding compound.

Deterioration of the blade may also have undesired effects on the final device. For example, excessive wear of the blade may cause metal smearing over the side surface of the package; in certain cases, such a smearing may cause, possibly after a plating step, an undesired electrical coupling (short) between two leads 12B and subsequent failure of the device.

Moreover, when cutting through long portions of metal (e.g., when removing the connecting bars CB) metal shavings may accumulate on the blade and eventually cause clogging of the blade.

The amount of metal to be cut may be reduced by using connecting bars CB and tie bars TB that are "half-etched", that is, have a reduced thickness ("half-etching" is a common designation in the art, which does not imply that such partial etching is by necessity to exactly half the thickness of the base sculptured structure of the leadframe) thus facilitating the sawing operation.

However, the thickness of the connecting bars CB and tie bars TB may not be reduced beyond a certain extent inasmuch these elements provide support of the parts of the leadframe strip S (such as die pads 12A and leads 12B) during processing.

Possible solutions to counter deterioration of the blade may comprise, for example, reducing the cutting speed or dividing the singulation process in several cutting steps; such solutions may however reduce the productivity.

Selecting certain types of blades (e.g., a "special" blade) or easier-to-cut substrate materials (e.g., alloys) may represents other options to consider. However, these solutions may lead to an increase of production costs and, in the case of a different material for the leadframe, reduce the electrical performance of the device.

Solutions as described herein aim at reducing the deterioration of the saw during the singulation step by reducing the amount of metallic material to be removed by providing apertures 100 (e.g., slits or slots cut through the bars CB) distributed along the length of the elongate sacrificial connecting bars CB.

These apertures 100 result in reduced resistance to the cutting action in so far as the amount of metallic material to be removed by cutting is reduced.

In solutions as described herein, the elongate sacrificial connecting bars CB are thus provided with an apertured structure comprising apertures 100 distributed along the length of the elongate sacrificial connecting bars CB.

Solutions as described herein do not involve additional processing steps and may be implemented with a (simple) modification of the leadframes forming step.

Figure 4 is a view the same portion of Figure 2 illustrated in Figure 3 showing an embodiment of the present description.

Like in Figure 3, in Figure 4 just a piece of the common substrate 12 is visible for simplicity with one ("horizontal", by way of example) cutting line SL illustrated at half height. The cutting line SL thus runs (extends) between adjacent substrate portions in the common electrically conductive substrate 12.

Figure 4 thus again shows adjacent substrate portions in the common electrically conductive substrate 12 that:
have mutually facing sides (above and below the cutting line SL in Figure 4), and
are coupled via connecting formations that comprise elongate (sacrificial) connecting bars CB extending between the mutually facing sides.

Singulating the devices 10 into individual semiconductor devices by cutting along "horizontal" and/or "vertical" cutting (sawing) lines SL as illustrated in Figure 2 again involves cutting the electrically conductive substrate 12 along the length of the elongate sacrificial connecting bars CB that are thus removed (hence the designation "sacrificial").

For example, as illustrated in Figure 4, apertures 100 may be provided in the portions of the connecting bars CB where tie bars TB branch off to the die pads 12A at locations distributed along the length of the connecting bars CB. However, the position exemplified in Figure 4 are not to be construed in a limiting sense of the embodiments in so far as other convenient locations may be chosen for the apertures 100.

The shape of the apertures 100 as illustrated in Figure 4 is also merely exemplary in so far as differently shaped apertures 100 may be realized. As exemplified in the figure, apertures 100 may have an elongated ("buttonhole") shape and may comprise terminal portions extending beyond (that is projecting away from) the sawing line SL.

A plurality of apertures 100 may be provided at different locations along the connecting bars CB with different shapes (also depending on the location and the room available therein) in order to reduce the amount of metal (e.g., copper) to be removed by the blade during the singulation step.

As illustrated, the apertures 100 may comprise slits (slots) extending transverse the elongate sacrificial connecting bars.

Tie bars TB may be provided distributed along the length of the elongate sacrificial connecting bars CB and coupling the elongate connecting bars CB to facing sides of the adjacent substrate portions in the common electrically conductive substrate 12; the apertured structure of the elongate sacrificial connecting bars CB may thus comprise apertures 100 provided at one or more of the tie bars TB.

The apertures 100 provided at the tie bars TB may comprise terminal ends extending into the tie bars TB.

Consequently, a final semiconductor device 10 obtainable with the method described herein may comprise at least one respective semiconductor chip 14 hosted (e.g., attached at a die pad 12A) on a portion 12A, 12B of an electrically conductive substrate, with that portion 12A, 12B of electrically conductive substrate 12 having one or more (remainders of) tie bars TB resulting from cutting along the connecting bars CB that project from a side. The at least one (remainder of) tie bar TB has an aperture (e.g., a notch 100') remaining at the distal end thereof.

As illustrated, the substrate portions in the common electrically conductive substrate 12 comprise die pads 12A that are configured to host respective semiconductor chips 14 (mounted, e.g., attached thereon). As illustrated, apertures 100 can be provided distributed along the length of the elongate sacrificial connecting bars CB at these die pads 12A. This arrangement was found to be beneficial in providing (mechanical) coupling between adjacent pads and thus increased rigidity of the substrate 12 during processing (e.g., mounting chips or dice 14 at the die pads, compression molding of the molding compound 20).

It is noted that such molding compound can penetrate into the apertured structure 100 of the elongate sacrificial connecting bars CB, this resulting in increased anchoring of the compound 20 to the substrate. This advantage can be appreciated also in the case the substrate 12 is of the "pre-molded" type.

Cutting (at the lines SL) the electrically conductive substrate 12 along the length of the elongate sacrificial connecting bars CB can thus be performed with the molding compound 20 penetrated into the apertured structure 100 of the elongate sacrificial connecting bars CB.

Such cutting can thus be performed once respective semiconductor chips 14 have been provided at the die pads 12A in the substrate portions 12A, 12B in the common electrically conductive substrate 12.

The number of apertures 100 may reflect a judicious trade-off between the reduction of (metal) material to be cut and the support/rigidity provided by the connecting bars CB to the leadframe strip: while reducing the resistance to cutting and countering other problems related to cutting, the reduction of (metal) material to be cut may in fact reduce the support/rigidity provided by the connecting bars CB to the leadframe strip S. The number of apertures 100 may thus depend on the design of the strip S and/or on the material of the strip S.

Apertures 100 may be provided during the formation of the substrate S (e.g., via stamping or etching), so that additional processing steps are avoided.

As discussed, a molding step is usually performed prior to cutting (singulation). In that way, the apertures 100 end up being filled with molding compound (e.g., an epoxy resin).

In certain embodiments, a pre-molded leadframe can be used as the substrate 12 and in that case the apertures 100 are (pre-)filled with (pre-)molding compound during the pre-molded leadframe forming step.

In either case, the provision of apertures 100 filled with compound results in a reduction of the amount of metal to be removed. It is likewise observed the provision of apertures 100 filled with compound facilitates clearing ("cleaning") the blade from the metallic shavings that may accumulate on the blade when cutting metal thus reducing the risk (or the frequency) of clogging of the blade.

A "cleaner" blade was found to reduce smearing of metal over the side surface of the package thus reducing the risk of an undesired electrical coupling (short-circuiting) of two leads 12B (and subsequent failure of the device).

Figure 5 reproduces on an enlarged scale the portion of Figure 4 indicated by arrow V as resulting from processing as described herein (cutting along the cutting line SL to remove the connecting bar CB and severing the tie bars TB).

As a consequence of an elongated shape of the apertures 100 (as illustrated in Figure 4), notches 100' may remain on the singulated device 10 at the "distal" (external) ends of the tie bars TB after the singulation step.

Figures 6A and 6B illustrate the bottom/back surface of a singulated device 10 produced in a conventional way (Figure 3) and according to embodiments of the present description (Figure 4 and 5), respectively.

Figures 6A and 6B refer to a finished device 10 including the protective plastic package of insulating molding compound 20 in order to highlight the differences visible also in the final package of the devices 10.

Apertures (e.g., notches) 100' may be visible on the side surface of the final package of the device 10 at the distal end portions of the tie bars TB left on the package after singulation.

The residual portion of the tie bars TB is not visible on the bottom/back surface of the finished device 10 as the tie bars TB have reduced ("half", in the sense explained earlier) thickness and are thus covered by molding compound 20 during the molding step.

Without prejudice to the underlying principles, the details and embodiments may vary, even significantly, with respect to what has been described by way of example only without departing from the extent of protection. The extent of protection is determined by the annexed claims.

## Claims

1. A method, comprising:
providing a common electrically conductive substrate (12) for a plurality of semiconductor devices, wherein the common substrate (12) comprises a plurality of substrate portions (12A, 12B) configured (12A) to host respective semiconductor chips (14), wherein adjacent substrate portions (12A, 12B) in the common electrically conductive substrate (12) have mutually facing sides with elongate sacrificial connecting bars (CB) extending between the mutually facing sides, and
cutting (SL) the common electrically conductive substrate (12) along the length of the elongate sacrificial connecting bars (CB) to provide singulated individual substrate portions (12A, 12B),
wherein the method comprises providing the elongate sacrificial connecting bars (CB) with an apertured structure comprising apertures (100) distributed along the length of the elongate sacrificial connecting bars (CB) .

2. The method of claim 1, wherein the apertures (100) comprise slits extending transverse the elongate sacrificial connecting bars (CB).

3. The method of claim 1 or claim 2, comprising providing tie bars (TB) distributed along the length of the elongate sacrificial connecting bars (CB) and coupling the elongate connecting bars (CB) to facing sides of adjacent substrate portions (12A, 12B) in the common electrically conductive substrate (12), wherein the apertured structure of the elongate sacrificial connecting bars (CB) comprises apertures (100) provided at said tie bars (TB).

4. The method of claim 3, wherein the apertures (100) provided at tie bars (TB) comprise terminal ends extending into the said tie bars (TB).

5. The method of any of the previous claims, wherein the plurality of substrate portions (12A, 12B) in the common electrically conductive substrate (12) comprise die pads configured (12A) to host respective semiconductor chips (14), wherein the method comprises providing apertures (100) distributed along the length of the elongate sacrificial connecting bars (CB) at said die pads (12A).

6. The method of any of the previous claims, comprising molding a molding compound (20) onto the common electrically conductive substrate (12), wherein the molding compound penetrates into the apertured structure (100) of the elongate sacrificial connecting bars (CB).

7. The method of claim 6, comprising cutting (SL) the common electrically conductive substrate (12) along the length of the elongate sacrificial connecting bars (CB) with the molding compound (20) penetrated into the apertured structure (100) of the elongate sacrificial connecting bars (CB).

8. The method of any of the previous claims, comprising:
providing respective semiconductor chips (14) at the plurality of substrate portions (12A) in the common electrically conductive substrate (12), and
cutting (SL) along the length of the elongate sacrificial connecting bars (CB) the electrically conductive substrate (12) having respective semiconductor chips (14) provided at the plurality of substrate portions (12A).

9. An electrically conductive substrate (12) for use as the common electrically conductive substrate in the method of any of the preceding claims, the electrically conductive substrate (12) comprising a plurality of substrate portions (12A, 12B) configured (12A) to host respective semiconductor chips (14), wherein adjacent substrate portions (12A, 12B) in the common electrically conductive substrate (12) have mutually facing sides and have elongate sacrificial connecting bars (CB) extending between the mutually facing sides, wherein the elongate sacrificial connecting bars (CB) have an apertured structure comprising apertures (100) distributed along the length of the elongate sacrificial connecting bars (CB).

10. The electrically conductive substrate (12) of claim 9, wherein:
the apertures (100) comprise slits extending transverse the elongate sacrificial connecting bars (CB),
and/or
tie bars (TB) are provided distributed along the length of the elongate sacrificial connecting bars (CB) to couple the elongate connecting bars (CB) to facing sides of the adjacent substrate portions in the common electrically conductive substrate (12), wherein the apertured structure of the elongate sacrificial connecting bars (CB) comprises apertures (100) provided at said tie bars (TB), wherein the apertures (100) provided at said tie bars (TB) preferably comprise terminal ends extending into the tie bars (TB),
and/or
the plurality of substrate portions (12A, 12B) in the electrically conductive substrate (12) comprise die pads configured (12A) to host respective semiconductor chips (14), wherein the electrically conductive substrate (12) comprises apertures (100) distributed along the length of the elongate sacrificial connecting bars (CB) at said die pads (12A).

11. A semiconductor device (10) obtainable with the method of claim 3 or claim 4, wherein the device (10) comprises at least one respective semiconductor chip (14) hosted (12A) on a portion (12A, 12B) of an electrically conductive substrate (12), wherein the portion (12A, 12B) of electrically conductive substrate (12) has at least one tie bar (TB) projecting from a side thereof, wherein the at least one tie bar (TB) has an aperture (100') provided at the distal end thereof.
